# EUROPEAN PATENT SPECIFICATION

(11) **EP 3 044 872 B1**
(45) Date of publication and mention of the grant of the patent: **14.08.2019**
(21) Application number: 14843253.7
(22) Date of filing: 27.08.2014
(51) Int. Cl.: H04N 5/378, H04N 5/357

(54) **AMPLIFIER ADAPTED FOR CMOS IMAGING SENSORS**
FÜR CMOS-BILDGEBUNGSSENSOREN ADAPTIERTER VERSTÄRKER
AMPLIFICATEUR CONÇU POUR DES CAPTEURS D'IMAGE CMOS

(30) Priority: 13.09.2013 US 201314026855
(43) Date of publication of application: 20.07.2016
(73) Proprietor: BAE Systems Imaging Solutions Inc., Nashua, NH 03061-0868 (US)
(72) Inventor: FOWLER, Boyd, Sunnyvale, CA 94086 (US); DO, Hung, T., San Jose, CA 95116 (US); LIU, Xinqiao, Mountain View, CA 94040 (US)
(74) Representative: BAE SYSTEMS plc Group IP Department
(86) International application number: PCT/US2014/052865
(87) International publication number: WO 2015/038336

(56) References cited:
- EP-A2- 0 813 338
- EP-A2- 2 448 254
- EP-B1- 0 657 863
- WO-A1-01/51894
- WO-A1-87/06711
- WO-A1-03/010495
- WO-A1-2009/067363
- WO-A1-2010/018706
- US-A- 6 111 606
- US-A1- 2002 050 940

## Description

### Background of the Invention

CMOS image sensors that are designed to operate at low illumination levels require very low noise readout circuits. A CMOS imaging sensor typically consists of a two- dimensional array of pixel sensors arranged as a plurality of rows and columns. Each pixel sensor includes a photodiode and a readout circuit that converts the charge accumulated by the photodiode during the image exposure to a voltage that is readout by a readout amplifier that is typically shared by all of the pixel sensors in a column. The pixel sensors in each row are readout in parallel using the column readout amplifiers. To maintain low noise, the time between the transfer of the photocharge to the readout circuits in the pixel sensors and the readout of that charge must be as small as possible, since noise accumulates in the pixel sensors during this phase.

To limit the noise in the column readout amplifiers, a low bandwidth amplifier is typically utilized. The lower the bandwidth of the amplifier, the lower the readout noise from the amplifier. However, lowering the bandwidth of the readout amplifier results in an increase in the time required to readout the pixel currently attached to the readout amplifier, since the reduced bandwidth amplifier takes longer to settle. Hence, there is a tradeoff between readout time and readout noise. Accordingly, reducing the noise in the column readout amplifiers remains a challenge in low light sensors.

EP 657863 B1 discloses a signal amplifier circuit provided with a buffer amplifier and an adjusting circuit for detecting a difference in voltage between a reference voltage (Vo) and an output voltage (Vo + DELTA V) of the buffer amplifier when the reference voltage (Vo) is inputted to the buffer amplifier as an offset voltage, and for inputting a voltage obtained by subtracting the offset voltage (DELTA V) from the voltage of an input signal so as to cancel out the offset voltage. An image display device of the invention includes the above signal amplifier circuit. According to that arrangement, the offset voltage (DELTA V) can be cancelled out. Therefore, the signal amplifier circuit has a buffer characteristic that a voltage having the same level as the voltage of the input signal can be outputted even if the offset voltage is generated in the buffer amplifier. By adopting the above signal amplifier circuit, an image display device which permits a high quality image display is said to be achievable.

WO 2003/010495 A1 discloses a circuit configuration comprising a measuring capacitor having a variable capacitance, which is set by means of a physical measured quantity to be detected, and comprising a reference capacitor and a buffer amplifier. An input of the buffer amplifier is at least temporarily coupled to the measuring capacitor whereby an output of the buffer amplifier supplies a signal voltage essentially proportional to a measuring voltage applied to the measuring capacitor. At the beginning of each measuring cycle, the measuring capacitor is discharged to a preset residual charge, whereas the reference capacitor is charged to a preset reference charge. Afterwards, the reference charge is transferred as completely as possible from the reference capacitor to the measuring capacitor. To this end, the input and output of the buffer amplifier are temporarily coupled to one another via the first reference capacitor during operation. The circuit configuration thus supplies a signal voltage according to a reciprocal value of the capacitance of the measuring capacitor and, in addition, has a current consumption that is said to be practically independent of the instantaneous capacitance of the measuring capacitor.

WO 2010/018706 A1 discloses a buffer circuit driving a capacitance load in accordance with voltage Vin. During a setup period, switches are in the ON state. During a drive period, a switch is in the ON state. A voltage comparison unit compares the voltage Vin of the setup period to the voltage Vo of the drive period and outputs a comparison result voltage. A push-pull output unit includes a TFT for charge and a TFT for discharge. A drive control unit controls the TFT to be in the OFF state during the setup period. During the drive period, the drive control unit selectively turns ON the TFT in accordance with the comparison result voltage. If Vout < Vin, the comparison result voltage increases, the TFT turns ON, voltage of a node (N6) decreases, the TFT turns ON, and the voltage Vout increases. Thus, it is said to be possible to provide a small-size capacitance load drive circuit having a low power consumption and robust against process irregularities.

EP 2448254 A2 discloses a solid-state image pickup device. The image pickup device includes a pixel including a photoelectric conversion element that converts light into an electric signal, a feedback amplifying circuit that amplifies a signal of the pixel using an amplification factor that is based on a variable feedback capacitor, a storage capacitor connected to an output node of the amplifying circuit via a first switch, and a load element connected to the output node of the amplifying circuit via a second switch. The second switch is in an on state during any one of or both of a period in which the feedback capacitor is reset and a period in which the first switch is in an on state.

US 6111606 A discloses a signal processor. The signal processor amplifies picture signals provided by an image sensor, samples the amplified picture signals and holds the samples of the amplified picture signals. The signal processor comprises a dual correlation sampling circuit, and a sample-and-hold circuit connected to the output part of the dual correlation sampling circuit. The dual correlation sampling circuit comprises an amplifying stage to which an input signal is given, a low-pass filter connected to the output part of the amplifying stage, a time constant changing switch to be closed to set the low-pass filter for a smaller time constant, and a switch driving means for closing the time constant changing switch after the completion of giving an input signal to the amplifying stage.

WO 2009/067363 A1 discloses a dual sensitivity image sensor. The image sensor provides a standard mode and a high- sensitivity mode of operation via iSoC integration. In addition to boosting sensitivity, the high sensitivity mode also reduces temporal noise thereby optimally boosting the Signal-to-Noise Ratio (SNR) of the image sensor. The document says that the circuit does not significantly increase pixel complexity and requires minimal changes to the support circuits in the iSoC including the addition of support and control circuitry to facilitate seamless mode change.

US 2002/050940 A1 discloses a signal transfer apparatus of high S/N ratio and high read speed suitable for use in photoelectric conversion circuit units with a large pixel count and an imaging apparatus and radiation image pick-up system. The signal transfer apparatus, comprises a plurality of terminals connected to a plurality of signal sources, and a read circuit unit for converting signals received from the terminals into series signals and outputting the resulting series signals. The read circuit unit comprises first operational amplifiers connected to the terminals, and second operational amplifiers for receiving outputs of the first operational amplifiers; and each of the first operational amplifiers comprises an inverting input terminal connected to each of the terminals, an output terminal with an integral capacitor and switch being connected in parallel between it and the inverting input terminal, and a non-inverting input terminal supplied with a reference voltage.

### Summary of the Invention

The present invention includes a column readout amplifier; as set out in claim 1 and method for using the same. The column readout amplifier includes a signal amplifier having an amplifier signal output, a first filter capacitor, a buffer amplifier having a buffer amplifier input and a buffer amplifier output, and a switching network. The switching network connects the amplifier signal output to the buffer amplifier input and the buffer amplifier output to the first filter capacitor during a first time period, and connects the amplifier signal output directly to the first filter capacitor during a second time period.

In one aspect of the invention, the signal amplifier charges the first filter capacitor with a first time constant when directly connected to the first filter capacitor. The first time period is less than five times the first time constant.

In another aspect of the invention, the column readout amplifier switches from the first time period to the second time period when the buffer amplifier input and the buffer amplifier output differ by less than a predetermined threshold. In another aspect of the invention, the first and second time periods are fixed in duration.

The column readout amplifier is adapted for use in an imaging array that includes a bit line conductor, a plurality of pixel sensors, each pixel sensor is coupled to the bit line conductor in response to a word select signal, and a column readout amplifier according to the present invention.

### Brief Description of the Drawings

Figure 1 illustrates a prior art readout amplifier connected to one pixel sensor in a column of pixel sensors.
Figure 2 illustrates a timing diagram for the readout of the pixel shown in Figure 1 via a conventional readout amplifier.
Figure 3 is a schematic drawing of a column readout amplifier according to the present invention.
Figure 4 is a timing diagram for the various signals shown in Figure 3.
Figure 5 illustrates an embodiment of the present invention that utilizes a higher gain amplifier to accelerate the charging of the filter capacitor.

### Detailed Description of the Preferred Embodiments of the Invention

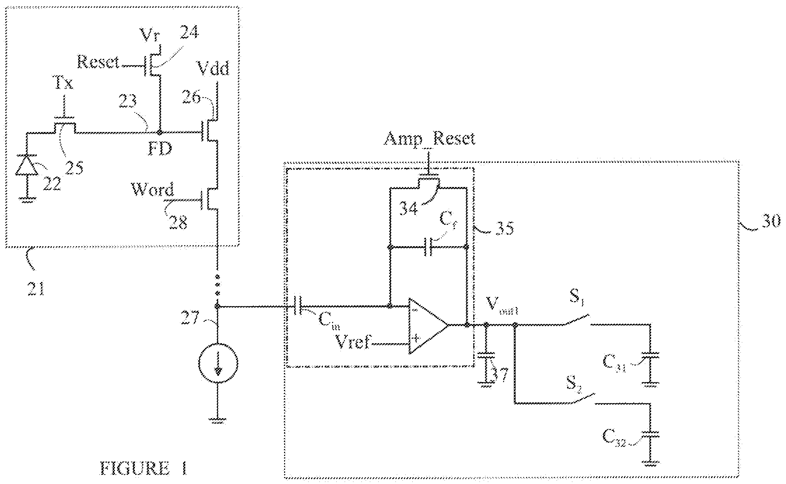

The manner in which the present invention provides its advantages can be more easily understood with reference to Figure 1. which illustrates a prior art column readout amplifier 30 connected to one pixel sensor in a column of pixel sensors. The particular pixel sensor that is connected to bit line 27 is determined by the signal on a corresponding word line 28. Pixel sensor 21 typically includes a photodiode 22 that accumulates charge during the image exposure. At the end of the image exposure, floating diffusion node 23 is reset to Vr by closing gate 24 using a signal on a reset line. The voltage on floating diffusion node 23 after the reset operation is measured via source follower 26 and column readout amplifier 30 is stored on in a sample and hold circuit on capacitor Cᵢₙ in column readout amplifier 30.

After this voltage measurement. gate 25 is placed in a conducting state in response to a signal on Tx. The positive potential on floating diffusion node 23 causes all of the charge on photodiode 22 to be transferred to floating diffusion node 23. The transferred charge results in a decrease in the potential of floating diffusion node 23 relative to the reset potential. The potential on floating diffusion node 23 is then measured by column readout amplifier 30 and stored in the sample and hold circuit on capacitor 32. The difference in voltage on capacitors 31 and 32 is then used to determine the charge that was generated by photodiode 22 during the exposure.

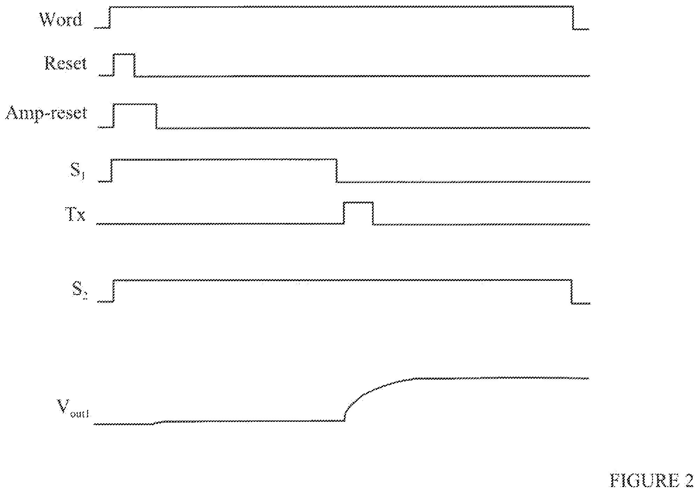

Refer now to Figure 2, which is a timing diagram for the readout of the pixel shown in Figure 1 via a conventional readout amplifier. Column readout amplifier 30 typically includes a capacitive transimpedance amplifier 35 constructed from Cᵢₙ and a feedback capacitor C_{f}. Prior to measuring the voltage on bit line 27, the input and output of capacitive transimpedance amplifier 35 are shorted by closing switch 34. The gain of capacitive transimpedance amplifier 35 is the ratio of the capacitances of capacitors Cᵢₙ and C_{f}, which is typically of the order of 30. Capacitor 37 sets the bandwidth of capacitive transimpedance amplifier 35. increasing capacitor 37 reduces the noise in the voltage measurements, since capacitor 37 sets the time constant of a low pass filter. However, the time for the output of capacitive transimpedance amplifier 35 to stabilize is also determined by capacitor 37, since capacitive transimpedance amplifier 35 must charge capacitor 37. This slow rise time limits the speed with which the pixels can be readout.

The present invention reduces the readout time of the column amplifier while using a large filter capacitor by providing a higher charging current for the capacitor during the earlier portion of the charging cycle for the filter capacitor. Once the potential on the capacitor is near its final value, the additional charging current is removed and the column readout amplifier is allowed to finish the charging operation. Since the potential on the filter capacity is near its final value when the additional amplification is removed, the time to settle to its final value is reduced, and hence, a larger capacitor can be utilized without increasing the readout time.

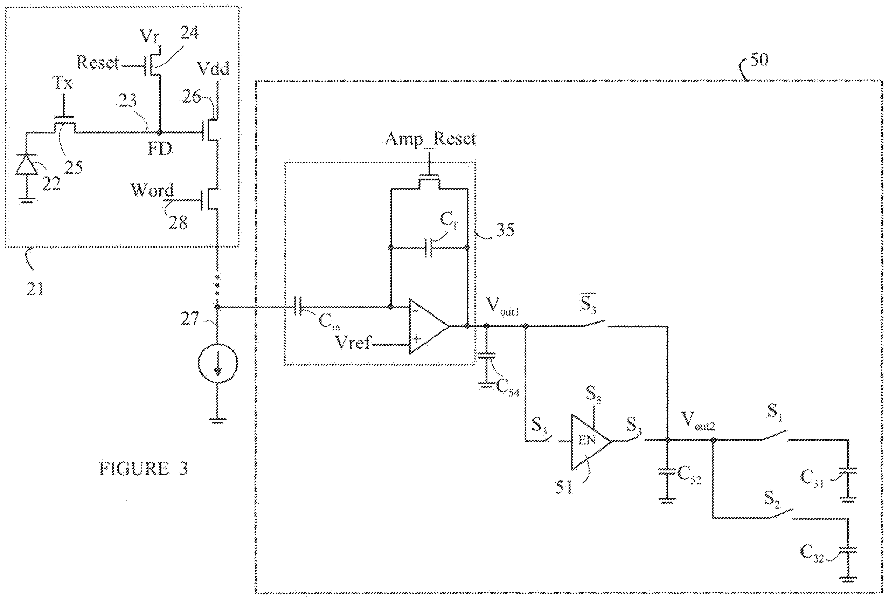

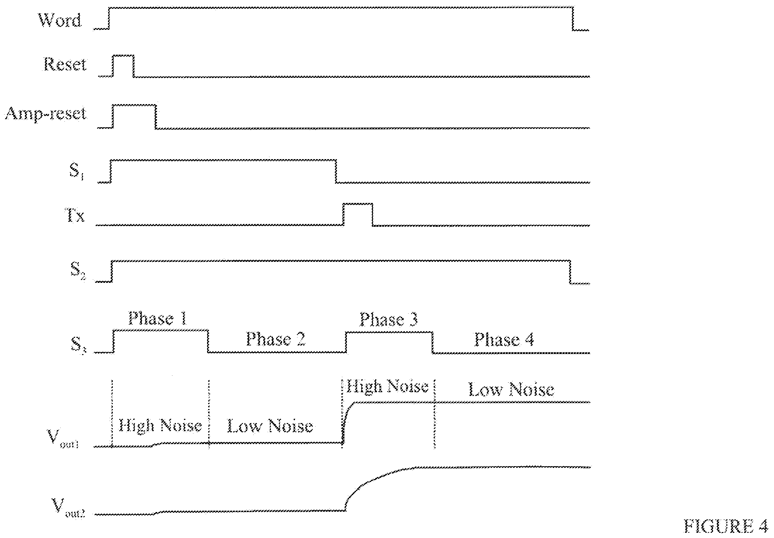

Refer now to Figures 3 and 4. Figure 3 is a schematic drawing of a column readout amplifier 50 according to the present invention, and Figure 4 is a timing diagram for the various signals shown in Figure 3. To simplify the following discussion, those elements of column readout amplifier 50 that serve functions analogous to those shown in Figure 2 for column readout amplifier 30 have been given the same numerical designations and will not be discussed further here. In column readout amplifier 50, capacitor C₅₂ serves the function of the filter capacitor 37 in Figure 1; however, the capacitance of C₅₂ is several times larger than that of capacitor 37. A readout operation using column readout amplifier 50 can be viewed as occurring in two phases. In the first phase, the voltage to be measured is transferred to Cᵢₙ and the switches operated by S₃ are closed. To simplify the drawing, the controller that generates the S₃ signal and its connections to the various switches have been omitted. As a result, Vₒᵤₜ₁, the output of capacitive transimpedance amplifier 35, is routed to a buffer amplifier 51 which charges capacitor C₅₂. Buffer amplifier 51 has a gain of one, and hence, the voltage on capacitor C₅₂ follows Vₒᵤₜ₁. However, the noise levels at Vₒᵤₜ₂ are considerably higher than those in Vₒᵤₜ₁ because of the high current gain. It should also be noted that the time for Vₒᵤₜ₁ to reach equilibrium is significantly reduced in column readout amplifier 50 because capacitor C₅₄ is much smaller than capacitor 37 in column readout amplifier 30.

At the end of the first phase, the voltage on C₅₂, Vₒᵤₜ₂, will be nearly Vₒᵤₜ₁. The differences in voltage will be the result of the increased noise from buffer amplifier 51 and any small differences in the gain of the buffer amplifier relative to the ideal gain of one. In general, the gain of buffer amplifier 51 is set to be substantially equal to one. The amount by which the gain can differ from one depends on the degree of mismatch of the potential on capacitor C₅₂ that can be tolerated. Any mismatch results in an increase in the time needed for capacitor C₅₂ to reach Vₒᵤₜ₁ after S₃ is opened. the amount of additional time that is required to reach equilibrium will, in general, depend on the specific application. An improvement over the prior art is obtained if the equilibrium time is less than that required in the absence of buffer amplifier 51.

During the second phase, the switches operated by S₃ are opened and buffer amplifier 51 is disconnected. The output of capacitive transimpedance amplifier 35 is hence connected directly to capacitor C₅₂. Any differences in voltage between Vₒᵤₜ₁ and Vₒᵤₜ₂ will then be eliminated by capacitive transimpedance amplifier 35. In addition, the noise level at capacitor C₅₂ will be that characterized by the sum of the capacitances of capacitors C₅₂ and C₅₄.

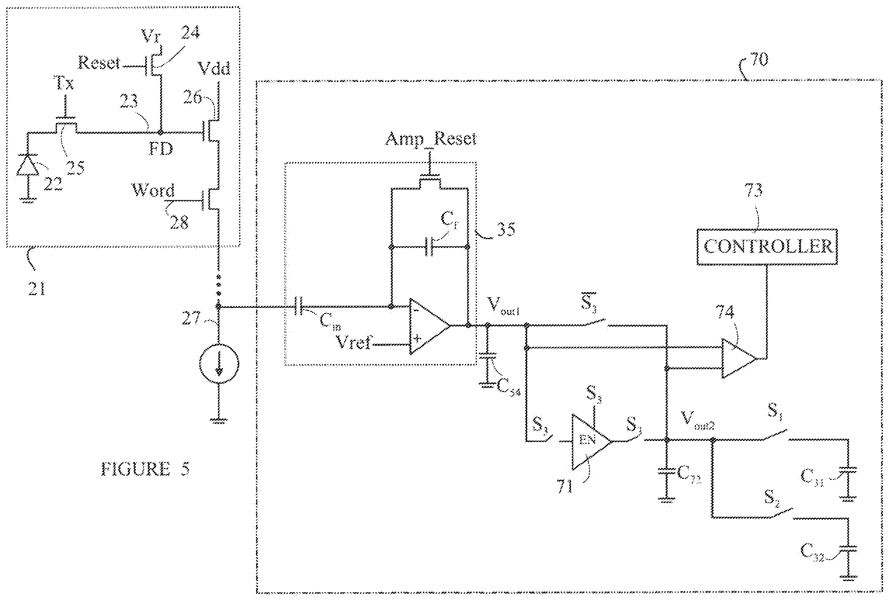

In the above-described embodiments, a unit gain buffer amplifier is used to accelerate the charge rate of the filter capacitor during the first phase of the readout. However, embodiments in which a higher gain factor is utilized together with a comparator to accelerate the charging of the filter capacitor can also be constructed. Refer now to Figure 5, which illustrates an embodiment of the present invention that utilizes a higher gain amplifier to accelerate the charging of the filter capacitor. To simplify the following discussion, those elements of column readout amplifier 70 that provide functions analogous to functions discussed above with respect to Figure 3, have been given the same numeric designations and will not be discussed in detail here. In column readout amplifier 70, amplifier 71 charges filter capacitor C₇₂ during the first phase of the readout operation. The gain of amplifier 71 is greater than one to further accelerate the initial charging of filter capacitor C₇₂. A comparator 74 monitors the voltage difference between the output of capacitive transimpedance amplifier 35 and filter capacitor C₇₂. When the monitored voltage difference is less than a predetermined threshold value, a switch controller 73 changes the state of the S₃ signal such that amplifier 71 is no longer connected to filter capacitor C₇₂. The final charging of filter capacitor C₇₂ is then provided by capacitive transimpedance amplifier 35 to provide lower noise in a time that is significantly less than the time required to charge filter capacitor C₇₂ to the final output voltage of capacitive transimpedance amplifier 35 without the precharging via amplifier 71. When the voltage has stabilized on capacitor C₇₂, controller 73 closes one of the sample switches to capture the voltage on capacitor C₇₂ on a corresponding one of the sample and hold capacitors, C₃₁ or C₃₂.

It should also be noted that the comparator arrangement shown in Figure 5 could also be utilized in embodiments with a unit gain buffer amplifier. In the above described embodiments that utilize a unit gain amplifier, the duration of the phases is set by predetermined time values. However, a comparator arrangement similar to that shown in Figure 5 could also be utilized with a unit gain amplifier to determine the time at which the column readout amplifier switches between the first and second phases. This arrangement can provide a reduced readout time, or lower noise by allowing a larger filter capacitor to be used. However, such embodiments require additional transistors to implement the comparator, and hence, can pose challenges if the available space for the column readout amplifiers is limited. In this regard, it should be noted that an imaging array may have thousands of such column readout amplifiers, and hence, even a few transistors per column readout amplifier can represent a significant, increase in the cost of the imaging array.

The above-described embodiments of the present invention have been provided to illustrate various aspects of the invention. However, it is to be understood that different aspects of the present invention that are shown in different specific embodiments can be combined to provide other embodiments of the present invention. In addition, various modifications to the present invention will become apparent from the foregoing description and accompanying drawings. Accordingly, the present invention is to be limited solely by the scope of the following claims.

## Claims

1. A column readout amplifier adapted for use in an imaging array that includes a bit line conductor and a plurality of pixel sensors, the amplifier comprising:
a signal amplifier (35) having an amplifier signal output;
a first filter capacitor (C₅₂);
a buffer amplifier (51) having a buffer amplifier input and a buffer amplifier output; and
a switching network (S₃),
**characterised in**
said switching network (S₃) connects said amplifier signal output to said buffer amplifier input and said buffer amplifier output to said first filter capacitor (C₅₂) during a first time period, and connects said amplifier signal output directly to said first filter capacitor (C₅₂) during a second time period, wherein said buffer amplifier output is disconnected from said first filter capacitor (C₅₂) during said second time period such that a higher charging current for the first filter capacitor is provided in the first time period compared to the second time period.

2. The column amplifier of Claim 1 wherein said signal amplifier (35) charges said first filter capacitor (C₅₂) with a first time constant when directly connected to said first filter capacitor (C₅₂) and wherein said first time period is less than five times said first time constant.

3. The column amplifier of Claim 1 wherein said buffer amplifier (51) has a gain substantially equal to one.

4. The column amplifier of Claim 1, wherein said column amplifier further comprises a controller (73) that measures a difference between said buffer amplifier input and buffer amplifier output, said controller (73) causing said column amplifier to switch from said first time period to said second time period when said difference is less than a predetermined threshold.

5. The column amplifier of Claim 1 wherein said first time period and said second time period are fixed.

6. The column amplifier of Claim 1 wherein said signal amplifier (35) comprises a capacitive transimpedance amplifier with a gain greater than one.

7. The column amplifier of Claim 1 wherein said first filter capacitor (C₅₂) is **characterized by** a first filter capacitor capacitance and said signal amplifier (35) comprises a second filter capacitor (C₅₄), **characterized by** a second filter capacitor capacitance, said second filter capacitor (C₅₄) being connected to said amplifier signal output, said second filter capacitor capacitance being less than five times said first filter capacitor capacitance.

8. An imaging array comprising: a bit line conductor (27);
a plurality of pixel sensors (21), each pixel sensor (21) being coupled to said bit line conductor (27) in response to a word select signal;
a column amplifier (50) according to Claim 1, said column amplifier connected to said bit line conductor (27).

9. The imaging array of Claim 8 wherein said buffer amplifier (51) charges said first filter capacitor (C₅₂) with a first time constant when directly connected to said first filter capacitor (C₅₂) and wherein said first time period is less than five times said first time constant.

10. The imaging array of Claim 8 wherein said buffer amplifier output is disconnected from said first filter capacitor (C₅₂) during said second time period.

11. The imaging array of Claim 8 wherein said signal amplifier (35) comprises a capacitive transimpedance amplifier with a gain greater than one.

12. The imaging array of Claim 8 wherein said first filter capacitor (C₅₂) is **characterized by** a first filter capacitor capacitance and said signal amplifier (35) comprises a second filter capacitor (C₅₄), **characterized by** a second filter capacitor capacitance, said second filter capacitor (C₅₄) being connected to said signal amplifier output, said second filter capacitor capacitance being less than five times said first filter capacitor capacitance.

13. The imaging array of Claim 8, wherein said first filter capacitor (C₅₂) is **characterized by** a first filter capacitor capacitance and wherein said imaging array further comprises a sample and hold circuit comprising a sample switch (SI) and a hold capacitor (C₃₁), said sample switch (SI) connecting said first filter capacitor (C₅₂) to said hold capacitor (C₃₁) in response to a control signal, said hold capacitor (C₃₁) being **characterized by** a capacitance less than five times said first filter capacitor capacitance.

## Patentansprüche

1. Spaltenausleseverstärker, eingerichtet für die Verwendung in einem Bildgebungsfeld, das einen Bitleitungsleiter und mehrere Pixelsensoren beinhaltet, wobei der Verstärker Folgendes umfasst:
einen Signalverstärker (35), der einen Verstärkersignalausgang aufweist,
einen ersten Filterkondensator (C₅₂),
einen Pufferverstärker (51), der einen Pufferverstärkereingang und einen Pufferverstärkerausgang aufweist, und
ein Vermittlungsnetz (S₃),
**dadurch gekennzeichnet, dass**
das Vermittlungsnetz (S₃) während einer ersten Zeitspanne den Verstärkersignalausgang mit dem Pufferverstärkereingang und den Pufferverstärkerausgang mit dem ersten Filterkondensator (C₅₂) verbindet und während einer zweiten Zeitspanne den Verstärkersignalausgang direkt mit dem ersten Filterkondensator (C₅₂) verbindet, wobei der Pufferverstärkerausgang während der zweiten Zeitspanne von dem ersten Filterkondensator (C₅₂) getrennt ist, so dass für den ersten Filterkondensator in der ersten Zeitspanne ein höherer Ladestrom bereitgestellt wird als in der zweiten Zeitspanne.

2. Spaltenverstärker nach Anspruch 1, wobei der Signalverstärker (35) den ersten Filterkondensator (C₅₂) mit einer ersten Zeitkonstante lädt, wenn er direkt mit dem ersten Filterkondensator (C₅₂) verbunden ist, und wobei die erste Zeitspanne weniger als das Fünffache der ersten Zeitkonstante beträgt.

3. Spaltenverstärker nach Anspruch 1, wobei der Pufferverstärker (51) eine Verstärkung aufweist, die im Wesentlichen gleich eins ist.

4. Spaltenverstärker nach Anspruch 1, wobei der Spaltenverstärker ferner eine Steuerung (73) umfasst, die eine Differenz zwischen dem Pufferverstärkereingang und dem Pufferverstärkerausgang misst, wobei die Steuerung (73) den Spaltenverstärker veranlasst, von der ersten Zeitspanne zur zweiten Zeitspanne zu schalten, wenn die Differenz kleiner als ein festgelegter Grenzwert ist.

5. Spaltenverstärker nach Anspruch 1, wobei die erste Zeitspanne und die zweite Zeitspanne feststehend sind.

6. Spaltenverstärker nach Anspruch 1, wobei der Signalverstärker (35) einen kapazitiven Transimpedanzverstärker mit einer Verstärkung von größer als eins umfasst.

7. Spaltenverstärker nach Anspruch 1, wobei der erste Filterkondensator (C₅₂) durch eine erste Filterkondensatorkapazität gekennzeichnet ist und der Signalverstärker (35) einen zweiten Filterkondensator (C₅₄) umfasst, der durch eine zweite Filterkondensatorkapazität gekennzeichnet ist, wobei der zweite Filterkondensator (C₅₄) mit dem Verstärkersignalausgang verbunden ist, wobei die zweite Filterkondensatorkapazität kleiner als das Fünffache der ersten Filterkondensatorkapazität ist.

8. Bildgebungsfeld, Folgendes umfassend:
einen Bitleitungsleiter (27),
mehrere Pixelsensoren (21), wobei jeder Pixelsensor (21) in Reaktion auf ein Wortauswahlsignal mit dem Bitleitungsleiter (27) gekoppelt wird,
einen Spaltenverstärker (50) nach Anspruch 1, wobei der Spaltenverstärker mit dem Bitleitungsleiter (27) verbunden ist.

9. Bildgebungsfeld nach Anspruch 8, wobei der Pufferverstärker (51) den ersten Filterkondensator (C₅₂) mit einer ersten Zeitkonstante lädt, wenn er direkt mit dem ersten Filterkondensator (C₅₂) verbunden ist, und wobei die erste Zeitspanne weniger als das Fünffache der ersten Zeitkonstante beträgt.

10. Bildgebungsfeld nach Anspruch 8, wobei der Pufferverstärkerausgang während der zweiten Zeitspanne von dem ersten Filterkondensator (C₅₂) getrennt ist.

11. Bildgebungsfeld nach Anspruch 8, wobei der Signalverstärker (35) einen kapazitiven Transimpedanzverstärker mit einer Verstärkung von größer als eins umfasst.

12. Bildgebungsfeld nach Anspruch 8, wobei der erste Filterkondensator (C₅₂) durch eine erste Filterkondensatorkapazität gekennzeichnet ist und der Signalverstärker (35) einen zweiten Filterkondensator (C₅₄) umfasst, der durch eine zweite Filterkondensatorkapazität gekennzeichnet ist, wobei der zweite Filterkondensator (C₅₄) mit dem Verstärkersignalausgang verbunden ist, wobei die zweite Filterkondensatorkapazität kleiner als das Fünffache der ersten Filterkondensatorkapazität ist.

13. Bildgebungsfeld nach Anspruch 8, wobei der erste Filterkondensator (C₅₂) durch eine erste Filterkondensatorkapazität gekennzeichnet ist und wobei das Bildgebungsfeld ferner eine Abtast- und Halteschaltung umfasst, die einen Abtastschalter (SI) und einen Haltekondensator (C₃₁) umfasst, wobei der Abtastschalter (SI) in Reaktion auf ein Steuersignal den ersten Filterkondensator (C₅₂) mit dem Haltekondensator (C₃₁) verbindet, wobei der Haltekondensator (C₃₁) durch eine Kapazität gekennzeichnet ist, die kleiner als das Fünffache der ersten Filterkondensatorkapazität ist.

## Revendications

1. Amplificateur de lecture de colonne conçu pour une utilisation dans un réseau de formation d'image qui comprend un conducteur de ligne de bit et une pluralité de capteurs de pixel, l'amplificateur comprenant :
un amplificateur de signal (35) ayant une sortie de signal d'amplificateur ;
un premier condensateur de filtrage (C₅₂) ;
un amplificateur tampon (51) ayant une entrée d'amplificateur tampon et une sortie d'amplificateur tampon ; et
un réseau de commutation (S₃),
**caractérisé en ce que**
ledit réseau de commutation (S₃) connecte ladite sortie de signal d'amplificateur à ladite entrée d'amplificateur tampon et ladite sortie d'amplificateur tampon audit premier condensateur de filtrage (C₅₂) pendant une première période de temps, et connecte ladite sortie de signal d'amplificateur directement audit premier condensateur de filtrage (C₅₂) pendant une deuxième période de temps, dans lequel ladite sortie d'amplificateur tampon est déconnectée dudit premier condensateur de filtrage (C₅₂) pendant ladite deuxième période de temps de sorte qu'un plus grand courant de charge pour le premier condensateur de filtrage soit fourni pendant la première période de temps comparée à la deuxième période de temps.

2. Amplificateur de colonne selon la revendication 1, dans lequel ledit amplificateur de signal (35) charge ledit premier condensateur de filtrage (C₅₂) avec une première constante de temps lorsqu'il est connecté directement audit premier condensateur de filtrage (C₅₂) et dans lequel ladite première période de temps est inférieure à cinq fois ladite première constante de temps.

3. Amplificateur de colonne selon la revendication 1, dans lequel ledit amplificateur tampon (51) a un gain sensiblement égal à 1.

4. Amplificateur de colonne selon la revendication 1, dans lequel ledit amplificateur de colonne comprend en outre un contrôleur (73) qui mesure une différence entre lesdites entrée d'amplificateur tampon et sortie d'amplificateur tampon, ledit contrôleur (73) amenant ledit amplificateur de colonne à commuter de ladite première période de temps à ladite deuxième période de temps lorsque ladite différence est inférieure à un seuil prédéterminé.

5. Amplificateur de colonne selon la revendication 1, dans lequel ladite première période de temps et ladite deuxième période de temps sont fixes.

6. Amplificateur de colonne selon la revendication 1, dans lequel ledit amplificateur de signal (35) comprend un amplificateur de transimpédance capacitif avec un gain supérieur à 1.

7. Amplificateur de colonne selon la revendication 1, dans lequel ledit premier condensateur de filtrage (C₅₂) est **caractérisé par** une première capacitance de condensateur de filtrage et ledit amplificateur de signal (35) comprend un deuxième condensateur de filtrage (C₅₄), **caractérisé par** une deuxième capacitance de condensateur de filtrage, ledit deuxième condensateur de filtrage (C₅₄) étant connecté à ladite sortie de signal d'amplificateur, ladite deuxième capacitance de condensateur de filtrage étant inférieure à cinq fois ladite première capacitance de condensateur de filtrage.

8. Réseau de formation d'image comprenant :
un conducteur de ligne de bit (27) ;
une pluralité de capteurs de pixel (21), chaque capteur de pixel (21) étant couplé audit conducteur de ligne de bit (27) en réponse à un signal de sélection de mot ;
un amplificateur de colonne (50) selon la revendication 1, ledit amplificateur de colonne étant connecté audit conducteur de ligne de bit (27).

9. Réseau de formation d'image selon la revendication 8, dans lequel ledit amplificateur tampon (51) charge ledit premier condensateur de filtrage (C₅₂) avec une première constante de temps lorsqu'il est connecté directement audit premier condensateur de filtrage (C₅₂) et dans lequel ladite première période de temps est inférieure à cinq fois ladite première constante de temps.

10. Réseau de formation d'image selon la revendication 8, dans lequel ladite sortie d'amplificateur tampon est déconnectée dudit premier condensateur de filtrage (C₅₂) pendant ladite deuxième période de temps.

11. Réseau de formation d'image selon la revendication 8, dans lequel ledit amplificateur de signal (35) comprend un amplificateur de transimpédance capacitif avec un gain supérieur à 1.

12. Réseau de formation d'image selon la revendication 8, dans lequel ledit premier condensateur de filtrage (C₅₂) est **caractérisé par** une première capacitance de condensateur de filtrage et ledit amplificateur de signal (35) comprend un deuxième condensateur de filtrage (C₅₄), **caractérisé par** une deuxième capacitance de condensateur de filtrage, ledit deuxième condensateur de filtrage (C₅₄) étant connecté à ladite sortie d'amplificateur de signal, ladite deuxième capacitance de condensateur de filtrage étant inférieure à cinq fois ladite première capacitance de condensateur de filtrage.

13. Réseau de formation d'image selon la revendication 8, dans lequel ledit premier condensateur de filtrage (C₅₂) est **caractérisé par** une première capacitance de condensateur de filtrage et dans lequel ledit réseau de formation d'image comprend en outre un circuit d'échantillonnage et de maintien comprenant un commutateur d'échantillonnage (SI) et un condensateur de maintien (C₃₁), ledit commutateur d'échantillonnage (SI) connectant ledit premier condensateur de filtrage (C₅₂) audit condensateur de maintien (C₃₁) en réponse à un signal de commande, ledit condensateur de maintien (C₃₁) étant **caractérisé par** une capacitance inférieure à cinq fois ladite première capacitance de condensateur de filtrage.
